(19) Europäisches Patentamt
European Patent Office
Office européen des brevets

(11) **EP 3 527 941 B1**

(12) **FASCICULE DE BREVET EUROPEEN**

(45) Date de publication et mention
de la délivrance du brevet:
**23.10.2024  Bulletin 2024/43**

(21) Numéro de dépôt: **19156305.5**

(22) Date de dépôt: **08.02.2019**

(51) Classification Internationale des Brevets (IPC):
**G01C 17/38** (2006.01)    **G01C 25/00** (2006.01)
**G01R 33/02** (2006.01)    **G01P 21/00** (2006.01)

(52) Classification Coopérative des Brevets (CPC):
**G01C 17/38; G01C 25/00; G01P 21/00;**
**G01R 33/0005; G01R 33/0206**

(54) **PROCÉDÉ DE CALIBRATION D'UN CAPTEUR TRI-AXE AVEC SELECTION D'UNE MÉTHODE DE CALIBRATION EN FONCTION DE LA DISTRIBUTION SPATIALE DES MESURES**

KALIBRIERVERFAHREN EINES DREIACHSIGEN SENSORS MIT AUSWAHL EINER KALIBRIERMETHODE IN ABHÄNGIGKEIT VON DER RÄUMLICHEN VERTEILUNG DER MESSUNGEN

METHOD FOR CALIBRATING A TRIAXIAL SENSOR WITH SELECTION OF A CALIBRATION METHOD ACCORDING TO THE SPATIAL DISTRIBUTION OF THE MEASUREMENTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **14.02.2018  FR 1851250**

(43) Date de publication de la demande:
**21.08.2019  Bulletin 2019/34**

(73) Titulaire: **Commissariat à l'énergie atomique et aux énergies alternatives**
**75015 Paris (FR)**

(72) Inventeur: **LEIRENS, Sylvain**
**38054 GRENOBLE CEDEX 09 (FR)**

(74) Mandataire: **Brevalex**
**Tour Trinity**
**1 B Place de la Défense**
**92400 Courbevoie (FR)**

(56) Documents cités:
**WO-A1-2007/026238      WO-A2-03/074969**

• **MATTHIAS GIETZELT: "Performance comparison of accelerometer calibration algorithms based on 3D-ellipsoid fitting methods", COMPUTER METHODS AND PROGRAMS IN BIOMEDICINE., vol. 111, no. 1, 1 July 2013 (2013-07-01), NL, pages 62 - 71, XP093152716, ISSN: 0169-2607, Retrieved from the Internet <URL:https://www.sciencedirect.com/science/article/pii/S0169260713000825/pdfft?md5=8cc05b2f9691ead6521d5d39bd07fd44&pid=1-s2.0-S0169260713000825-main.pdf> DOI: 10.1016/j.cmpb.2013.03.006**

**Description**

**DOMAINE TECHNIQUE**

Le domaine de l'invention est celui de la calibration d'un capteur tri-axe. L'invention concerne plus particulièrement une calibration automatique réalisée de manière continue alors que le capteur est en cours d'utilisation.

**ÉTAT DE LA TECHNIQUE ANTÉRIEURE**

Un magnétomètre peut être intégré à une centrale inertielle de navigation pour réaliser une mesure du champ magnétique terrestre, ce qui permet de déterminer le cap d'un dispositif embarquant ladite centrale.

En l'absence d'erreurs et de perturbation locales, le magnétomètre mesure uniquement le vecteur de champ magnétique terrestre. Toutefois, lorsque la centrale inertielle est contaminée par certaines erreurs, la mesure du vecteur de champ magnétique terrestre est différente de la valeur réelle du vecteur de champ magnétique terrestre, appelée valeur de référence. Les erreurs présentes sur les mesures du magnétomètre ne se limitent pas qu'aux erreurs intrinsèques du capteur, comme le facteur d'échelle, le mauvais alignement et le biais, mais peuvent également être causées par l'environnement extérieur, notamment les erreurs de fer dur qui proviennent d'une présence de matériaux magnétisés, tels que ceux présents dans les composants électroniques, le circuit d'alimentation, etc., et les erreurs de fer doux qui sont générées par la déformation des lignes de champ magnétique dans l'environnement extérieur au capteur, par exemple due à la présence de câbles, de vis et d'écrous métalliques, etc.

Le magnétomètre doit donc être calibré pour corriger les mesures brutes des erreurs mentionnées ci-dessus. Cette problématique se pose également pour les autres capteurs de la centrale inertielle, à savoir pour l'accéléromètre et le gyromètre.

La plupart des algorithmes de calibration reposent sur une méthode d'ajustement des mesures brutes sur une surface paramétrique, typiquement un ellipsoïde, l'écart entre cet ellipsoïde et une sphère de rayon égal à la norme du champ magnétique terrestre dans le cas d'un magnétomètre étant représentatif des erreurs affectant le magnétomètre. La transformation qui permet de passer de l'ellipsoïde à la sphère est alors appliquée aux mesures brutes pour les corriger des erreurs susmentionnées.

Pour que ces algorithmes de calibration soient efficaces et à même de fournir des paramètres de calibration suffisamment précis, il est nécessaire de pouvoir acquérir des mesures bien distribuées, à savoir des points couvrant l'intégralité de l'ellipsoïde. Or en pratique, en cours d'utilisation du magnétomètre, les mesures qui peuvent être collectées sont généralement mal distribuées et ne couvrent pas certaines parties de l'ellipsoïde.

Cette constatation est notamment faite dans l'article de A. Olivares et al. "Automatic Détermination of Validity of Input Data Used in Ellipsoid Fitting MARG Calibration Algorithms," Sensors, vol. 13, no. 9, pp. 11797-11817, Sep. 2013. Les auteurs de cet article montrent ainsi qu'une erreur des algorithmes d'ajustement à un ellipsoïde peut être déterminée en analysant la distribution spatiale des mesures brutes du magnétomètre. Ces auteurs proposent alors de ne mettre en oeuvre ces algorithmes de calibration que lorsque l'erreur attendue est inférieure à un seuil. Cet article indique que le meilleur indicateur de validité de la distribution des mesures brutes est celui de l'enveloppe convexe. Cet indicateur présente toutefois l'inconvénient de nécessiter d'importantes ressources de calcul.

WO 03/074969 A2 décrit la calibration d'un magnétomètre tri-axe au moyen d'un ajustement sur une surface paramétrique. Cet ajustement est réalisé par itération pour obtenir le meilleur ajustement au sens d'un indicateur de la qualité de l'ajustement, par exemple au sens des moindres carrés.

WO 2007/026238 A1 D2 présente les principes généraux de la calibration par ajustement des mesures sur une surface paramétrique et détermination de la transformation permettant de passer de la surface paramétrique à la sphère unité. **EXPOSÉ DE L'INVENTION** L'invention porte sur un procédé selon la revendication 1, un programme d'ordinateur selon la revendication 9 et un dispositif selon la revendication 10.

L'invention a pour objectif de perfectionner les techniques connues de calibration, et propose pour ce faire un procédé mis en oeuvre par ordinateur de calibration d'un capteur tri-axe comprenant des étapes de calcul d'un indicateur de distribution spatiale d'un ensemble de mesures délivrées par le capteur tri-axe et de détermination, selon une méthode d'ajustement, de paramètres d'une surface paramétrique permettant d'ajuster ladite surface audit ensemble de mesures. La méthode d'ajustement est plus particulièrement sélectionnée parmi plusieurs méthodes d'ajustement prédéterminées en fonction dudit indicateur de distribution spatiale.

Certains aspects préférés mais non limitatifs de ce procédé sont les suivants :

- les méthodes d'ajustement prédéterminées comprennent ou consistent en une méthode d'ajustement à un ellipsoïde, une méthode d'ajustement à une sphère et une méthode d'ajustement en deux étapes consistant en un premier ajustement à une sphère suivi d'un deuxième ajustement à un ellipsoïde dont le centre est confondu avec le centre de la sphère du premier ajustement ;
- lorsque l'indicateur de distribution spatiale est inférieur à un premier seuil, la méthode d'ajustement sélectionnée est la méthode d'ajustement à un ellipsoïde, lorsque l'indicateur de distribution spatiale est supérieur au premier seuil et inférieur à un deuxième seuil, la méthode d'ajustement sélectionnée est la méthode d'ajustement en deux étapes, et lorsque l'indicateur de distribution spatiale est supérieur au deuxième seuil, la méthode d'ajustement sélectionnée est la méthode d'ajustement à une sphère ;

- il comprend une étape préalable de sélection des mesures dudit ensemble parmi les mesures délivrées par le capteur tri-axe, ladite étape préalable comprenant une estimation d'un changement d'orientation du capteur tri-axe entre les mesures délivrées et la sélection de mesures associées à des orientations du capteur jugées, au moyen d'une comparaison à un seuil, comme étant suffisamment différentes ;

- le capteur tri-axe est un magnétomètre et l'estimation d'un changement d'orientation du capteur entre les mesures comprend la détermination de l'écart entre l'amplitude d'une composante d'une mesure avec les amplitudes de composantes de mesures préalablement sélectionnées ;

- le capteur tri-axe est un magnétomètre et l'estimation d'un changement d'orientation du magnétomètre entre les mesures exploite des mesures délivrées par un gyromètre, ou les mesures délivrées par le magnétomètre et des mesures délivrées par un accéléromètre ;

- il comprend la détermination d'une transformation test permettant de transformer la surface paramétrique ajustée audit ensemble de mesures en une sphère unité, l'application de la transformation test aux mesures dudit ensemble pour fournir des mesures transformées et la détermination d'un degré d'ajustement des mesures transformées à la sphère unité ;

- il comprend en outre l'application d'une transformation de calibration courante aux mesures dudit ensemble pour fournir des mesures calibrées, la détermination d'un degré d'ajustement des mesures calibrées à la sphère unité et la sélection de la transformation test en tant que nouvelle transformation de calibration courante si le degré d'ajustement des mesures transformées à la sphère unité est supérieur au degré d'ajustement des mesures calibrées à la sphère unité.

**BRÈVE DESCRIPTION DES DESSINS**

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- les figures 1a et 1b représentent des exemples de distribution spatiale de mesures délivrées par un magnétomètre ;

- la figure 2 est un ordinogramme représentant les différentes étapes du procédé selon l'invention ;

- les figures 3a et 3b représentent respectivement une surface paramétrique ajustée à un ensemble de mesures d'un magnétomètre selon une méthode d'ajustement à un ellipsoïde en une étape et les mesures calibrées par application de la transformation permettant de passer de cette surface à la sphère unité ;

- les figures 4a et 4b représentent respectivement une surface paramétrique ajustée à un ensemble de mesures du magnétomètre selon une méthode d'ajustement en deux étapes et les mesures calibrées par application de la transformation permettant de passer de cette surface à la sphère unité, l'ensemble de mesures étant identique à celui des figures 3a et 3b.

**EXPOSÉ DÉTAILLÉ DE MODES DE RÉALISATION PARTICULIERS**

L'invention porte sur un procédé mis en oeuvre par ordinateur de calibration d'un capteur tri-axe et plus particulièrement sur une calibration automatique réalisée alors que le capteur tri-axe est en cours d'utilisation. Le capteur est typiquement intégré au sein d'une centrale inertielle de navigation. On prendra dans ce qui suit l'exemple non limitatif d'un magnétomètre, l'invention s'étendant à d'autres types de capteur, notamment à un accéléromètre et/ou à un gyromètre.

La mesure X des trois composantes du champ magnétique terrestre $B_r$ réalisée par un magnétomètre est affectée d'erreurs qui peuvent être modélisées sous la forme matricielle suivante : $X = W.B_r + b$, où b représente un biais principalement introduit par les interférences de fer dur et W est une matrice 3*3 pouvant se décomposer selon $W = W_{gain}.W_{mis}.W_{soft}$ avec $W_{gain}$ une matrice diagonale modélisant les erreurs de facteur d'échelle, $W_{mis}$ une matrice modélisant les erreurs de défauts d'alignement (non-orthogonalité) des axes de mesure et $W_{soft}$ une matrice modélisant les erreurs introduites par les interférences de fer doux. On a ainsi

$$W_{gain} = \begin{pmatrix} g_x & 0 & 0 \\ 0 & g_y & 0 \\ 0 & 0 & g_z \end{pmatrix}$$ et

$$W_{mis} = \begin{pmatrix} 1 & -\epsilon_z & \epsilon_y \\ \epsilon_z & 1 & -\epsilon_x \\ -\epsilon_z & \epsilon_x & 1 \end{pmatrix}$$ . La calibration du magnétomètre vise à identifier W et b pour ensuite calculer des mesures calibrées débarrassées des erreurs : $X_c = W^{-1}(X-b)$.

En l'absence de perturbations, le magnétomètre mesure un champ 3D constant. En modifiant l'orientation du magnétomètre dans ce champ constant, les mesures devraient être portées par une sphère. Mais les biais, les facteurs d'échelle et les défauts d'alignement transforment cette sphère en une surface quadratique, typiquement un ellipsoïde. Une technique de calibration consiste alors à déterminer les paramètres d'une surface paramétrique qui permettent d'ajuster ladite surface aux mesures, puis de déterminer la transformation inverse qui va transformer cette surface en la sphère unité. Cette transformation inverse est alors appliquée aux mesures, de manière à fournir des mesures calibrées débarrassées des erreurs susmentionnées.

Comme indiqué précédemment, pour que cette technique de calibration permette de fournir des paramètres de calibration ($D=W^{-1}$ et b) suffisamment précis, il est nécessaire que les mesures soient spatialement bien distribuées en ce sens qu'elles couvrent l'intégralité de l'ellipsoïde. L'invention propose de calculer un indicateur de la bonne ou mauvaise distribution spatiale des mesures, et d'utiliser cet indicateur comme critère pour sélectionner une méthode d'ajustement d'une surface paramétrique aux mesures parmi plusieurs méthodes d'ajustement prédéterminées.

Comme rappelé dans l'article précité de A. Olivares et al., une équation de la forme $X=W.B_r+b$ s'applique également aux autres capteurs de la centrale inertielle, en remplaçant Br par le champ gravitationnel terrestre dans le cas de l'accéléromètre (sa norme est généralement de 1 si l'unité de mesure de l'accélération est g) et en remplaçant Br par une vitesse angulaire constante dans le cas du gyromètre.

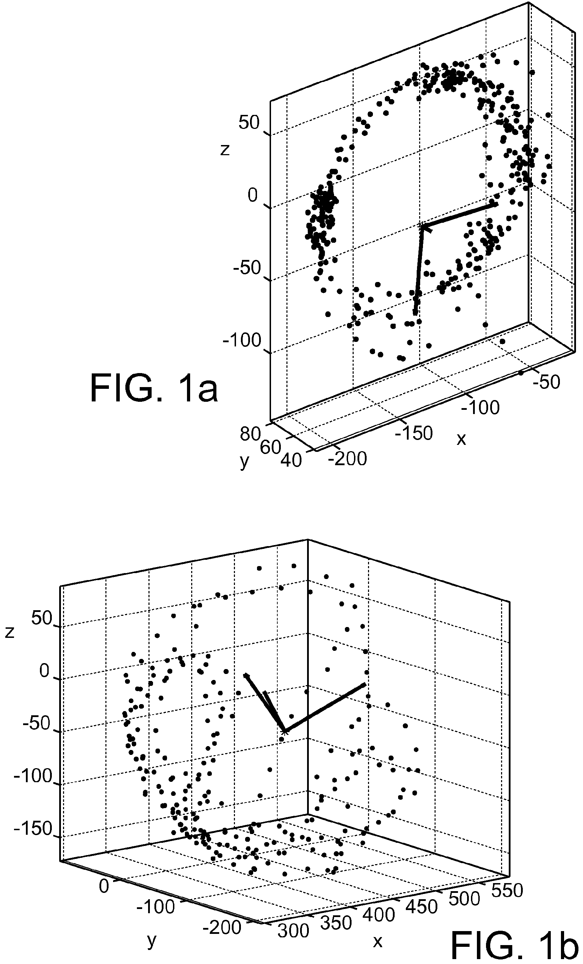

On a représenté sur les figures 1a et 1b des exemples de distribution spatiale de mesures délivrées par le magnétomètre. Sur la figure 1a, les mesures sont quasiment coplanaires et donc particulièrement mal distribuées. Au contraire, sur la figure 1b, les mesures couvrent correctement la surface d'un ellipsoïde et apparaissent donc bien distribuées. Selon l'invention, la méthode d'ajustement utilisée pour déterminer les paramètres de la surface paramétrique à ajuster aux mesures sera différente pour les mesures des figures 1a et 1b.

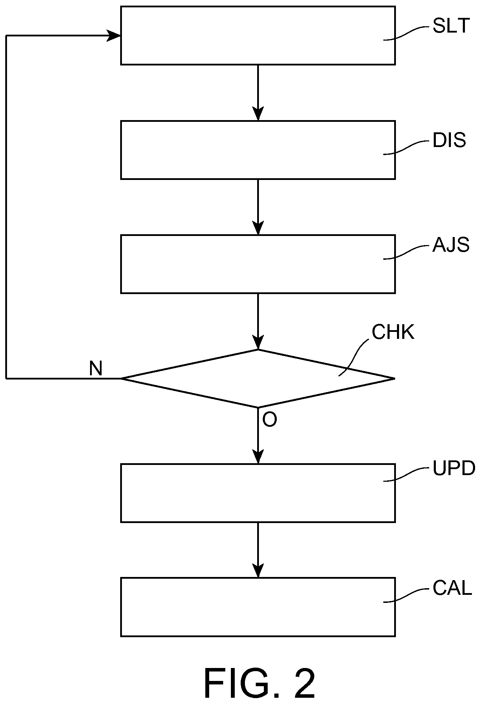

En référence à la figure 2, le procédé selon l'invention comprend plus particulièrement une étape de calcul DIS d'un indicateur de distribution spatiale d'un ensemble de mesures délivrées par le magnétomètre. Le procédé comprend en outre une étape de détermination AJS, selon une méthode d'ajustement, de paramètres d'une surface paramétrique permettant d'ajuster la surface paramétrique à l'ensemble de mesures délivrées par le magnétomètre. La méthode d'ajustement est sélectionnée parmi plusieurs méthodes d'ajustement prédéterminées en fonction de l'indicateur de distribution spatiale calculé lors de l'étape de calcul DIS.

Les méthodes d'ajustement prédéterminées peuvent notamment comprendre une méthode d'ajustement à un ellipsoïde, une méthode d'ajustement à une sphère et une méthode d'ajustement en deux étapes consistant en un premier ajustement à une sphère suivi d'un deuxième ajustement à un ellipsoïde dont le centre est confondu avec le centre de la sphère du premier ajustement. Dans une variante de réalisation, les méthodes d'ajustement prédéterminées peuvent consister en ces trois méthodes précitées. Les méthodes d'ajustement à un ellipsoïde et à une sphère sont dites à une étape en ce qu'elles visent directement un ajustement à la surface paramétrique concernée, par opposition à une méthode d'ajustement en deux étapes qui comprend un premier ajustement suivi d'un deuxième ajustement qui exploite les résultats du premier ajustement.

La méthode d'ajustement à un ellipsoïde peut comprendre un ajustement à un ellipsoïde tourné (« rotated ellipsoid ») nécessitant la détermination de 9 paramètres ou un ajustement à un ellipsoïde non tourné (« non-rotated ellipsoid ») nécessitant la détermination de 6 paramètres.

Un exemple d'une méthode d'ajustement en deux étapes est notamment décrit dans l'article de M. Gietzelt et al., "Performance comparison of accelerometer calibration algorithms based on 3D-ellipsoid fitting methods" Comput. Methods Programs Biomed., vol. 111, no. 1, pp. 62-71, Jul. 2013.

La méthode d'ajustement à une sphère nécessite la détermination de 4 paramètres. Elle est utilisée pour calculer les biais liés aux interférences de fer dur et approximer les facteurs d'échelle. Elle fournit une calibration considérée comme un mode dégradé.

A titre d'exemple, l'indicateur de distribution spatiale est d'autant plus faible que les mesures sont bien distribuées. Alors, dans une réalisation possible, lorsque l'indicateur de distribution spatiale est inférieur à un premier seuil, la méthode d'ajustement sélectionnée est la méthode d'ajustement à une ellipsoïde (en une étape), lorsque l'indicateur de distribution spatiale est supérieur au premier seuil et inférieur à un deuxième seuil, la méthode d'ajustement sélectionnée est la méthode d'ajustement en deux étapes, et lorsque l'indicateur de distribution spatiale est supérieur au deuxième seuil, la méthode d'ajustement sélectionnée est la méthode d'ajustement à une sphère (en une étape). Bien entendu, d'autres seuils peuvent être prévus, comme par exemple un seuil pour départager un ajustement à un ellipsoïde tourné d'un ajustement à un ellipsoïde non tourné.

Dans un mode de réalisation de l'invention, l'invention adopte une approche de type analyse en composantes principales pour évaluer la dispersion des mesures. Plus précisément, le calcul DIS de l'indicateur de distribution spatiale comprend la détermination de la matrice de corrélation des mesures de l'ensemble de mesures et la détermination du nombre de conditionnement de la matrice de corrélation.

On considère un ensemble de N mesures des trois composantes du champ magnétique et Xm la matrice 3*N des mesures centrées. Le centre c des mesures est calculé par la méthode "min-max-average". Par exemple pour l'axe x, $c_x = (m_{x,min} + m_{x,max})/2$, où $m_{x,min}$ et $m_{x,max}$ représentent respectivement le minimum et le maximum de l'ensemble des mesures sur l'axe x. Alternativement, le centre des mesures peut être calculé en utilisant la moyenne ou la médiane des mesures, mais en pratique, l'ensemble des mesures est souvent mal distribué, et le centre peut se trouver trop éloigné de la moyenne (ou médiane).

La matrice de corrélation S s'exprime selon

$$S = \frac{1}{N-1}(X_m X_m^T)$$

. Les valeurs propres $\lambda_i$ ($i \in \{1,2,3\}$) de la matrice S sont représentatives des variances des mesures le long de chaque vecteur propre. Les valeurs propres $\lambda_i$ contiennent donc de l'information utile à propos de la dispersion des mesures. Plus particulièrement, le nombre de conditionnement de la matrice S, à savoir le ratio de la valeur propre la plus grande sur la valeur propre la plus faible, est d'autant plus proche de 1 que les mesures sont bien distribuées et d'autant plus grand que les mesures sont mal distribuées. Ce nombre de

$$r = \frac{\max_i \lambda_i}{\min_i \lambda_i}$$

conditionnement s'écrit et est utilisé pour sélectionner la méthode d'ajustement à utiliser. Par exemple, lorsque r est inférieur à un premier seuil $r_1$, la méthode d'ajustement sélectionnée est la méthode d'ajustement à un ellipsoïde (en une étape), lorsque r est supérieur au premier seuil $r_1$ et inférieur à un deuxième seuil $r_2$, la méthode d'ajustement sélectionnée est la méthode d'ajustement en deux étapes, et lorsque r est supérieur au deuxième seuil $r_2$, la méthode d'ajustement sélectionnée est la méthode d'ajustement à une sphère (en une étape).

Le procédé selon l'invention peut comprendre une étape préalable SLT de sélection des mesures dudit ensemble parmi les mesures délivrées par le magnétomètre. Cette étape préalable comprend une estimation d'un changement d'orientation du magnétomètre entre les mesures et la sélection de mesures associées à des orientations du magnétomètre jugées, par exemple au moyen d'une comparaison à un seuil, comme étant suffisamment différentes. En s'assurant que les mesures sélectionnées sont réalisées pour différentes orientations du magnétomètre, on favorise le fait que ces mesures puissent couvrir un ellipsoïde.

L'estimation d'un changement d'orientation du magnétomètre peut exploiter les mesures délivrées par le magnétomètre. Cette estimation peut comprendre l'évaluation d'une mesure en venant déterminer, pour chaque composante de la mesure évaluée, l'écart $|\xi - \xi_n|$ entre l'amplitude $\xi$ de la composante de la mesure évaluée et l'amplitude $\xi_n$ d'une composante d'une mesure préalablement sélectionnée dans ledit ensemble. Si pour toutes les mesures préalablement sélectionnées dans ledit ensemble, cet écart est supérieur à un seuil prédéterminé $\tau_{mag}$, par exemple égal à $10\mu T$, la mesure évaluée est sélectionnée. En pratique, il suffit de comparer $\xi$ avec l'amplitude de la composante de la dernière mesure sélectionnée (ici désignée par l'indice n).

L'estimation d'un changement d'orientation du magnétomètre peut exploiter les mesures délivrées par un gyromètre, par exemple lorsque le magnétomètre est intégré dans une centrale inertielle. Une mesure magnétométrique associée à une mesure du vecteur vitesse angulaire délivrée par le gyromètre dont une composante $\omega \in \{\omega_x, \omega_y, \omega_z\}$ est supérieure à un seuil $\tau_{gyr}$, par exemple de 30°/s, est alors sélectionnée.

En variante, les mesures délivrées par le gyromètre sont utilisées pour estimer une différence d'orientation du gyromètre entre un instant actuel et un instant précédent correspondant à la dernière sélection d'une mesure. Selon cette variante, on procède à l'estimation de l'attitude relative du gyromètre au moyen d'une intégration temporelle des mesures délivrées par le gyromètre, en considérant que les biais du gyromètre sont compensés ou simplement en les négligeant. La formule de

$$\dot{q}(t) = \frac{1}{2} q(t) \otimes \overline{\omega}(t)$$

dérivation du quaternion, , peut être discrétisée selon la méthode d'Euler pour calculer l'orientation actuelle $q(t)$ à partir de $\omega(\eta)$ pour $\eta \in [t_n, t]$, avec $t_n$ l'instant correspondant à la dernière sélection d'une mesure. Une erreur $q_e$ est calculée, représentative d'une différence d'orientation entre le quaternion actuel $q(t)$ et le quaternion associée à la dernière mesure

sélectionnée $q(t_n)$, selon $q_e = q(t) \otimes q_0^*$ . L'angle de $q_e$ dans la représentation axe-angle (« axis-angle ») du quaternion $q_e$ est donné par $\alpha = \cos^{-1} q_{e,0}$, où $q_{e,0}$ est la partie réelle de l'erreur $q_e$. La mesure magnétométrique actuelle est sélectionnée si $\alpha > \tau_{gyrInt}$, avec $\tau_{gyrInt}$ un seuil par exemple de 30°.

L'estimation d'un changement d'orientation du magnétomètre peut également exploiter les mesures délivrées par le magnétomètre et par un accéléromètre, par exemple lorsque le magnétomètre est intégré dans une centrale inertielle. La méthode TRIAD peut à ce titre être utilisée pour rechercher des mesures magnétométriques réalisées à des angles suffisamment différents. Comme pour l'approche précédente, on calcule un angle $\alpha$ en tant que différence entre l'orientation actuelle $q(t)$ et l'orientation correspondant associée à la dernière mesure sélectionnée, $\alpha = \cos^{-1} q_{e,0}$, et la mesure magnétométrique actuelle est sélectionnée si $\alpha > \tau_{acc}$, avec $\tau_{acc}$ un seuil par exemple de 30°. Cette approche ne nécessite pas de stocker les mesures gyrométriques pour réaliser l'intégration temporelle puisque des orientations absolues sont calculées à partir des mesures délivrées par le magnétomètre et par l'accéléromètre. Cette approche repose toutefois sur l'hypothèse d'une absence d'accélération linéaire.

Une ou plusieurs autres contraintes peuvent être utilisées lors de cette étape préalable de sélection des mesures magnétométriques pour constituer ledit ensemble servant de référence pour l'ajustement d'une surface paramétrique. Une première contrainte consiste par exemple en une durée minimum entre deux mesures successivement sélectionnées, par exemple 0,1s. Une autre contrainte consiste par exemple une durée maximum entre deux mesures successivement sélectionnées, par exemple 1s. Si cette durée est dépassée, l'étape préalable est réinitialisée. Encore une autre contrainte concerne le nombre de mesures à sélectionner, avec par exemple un nombre minimal et un nombre maximal de mesures, par exemple entre 100 et 200 mesures devant être sélectionnées lors de l'étape préalable.

Suite à l'étape de détermination AJS, selon la méthode d'ajustement sélectionnée, des paramètres de la surface paramétrique, le procédé selon l'invention peut comprendre une étape CHK de vérification de la qualité de l'ajustement.

Cette étape de vérification CHK peut comprendre l'étude de propriétés analytiques des matrices impliquées dans l'ajustement. Cette étude peut ainsi venir vérifier si la matrice représentant les mesures est une matrice de plein rang au sens des moindres carrés. En effet, des mesures strictement coplanaires ne forment pas une matrice de plein rang. Cette étude peut également venir étudier la matrice représentant la surface paramétrée à l'aide des paramètres déterminés à l'étape AJS. Les méthodes d'ajustement à un ellipsoïde ont effectivement pour objectif d'identifier une matrice symétrique définie positive $A$ apparaissant dans l'équation $(X - b)^{\mathrm{T}} A(X - b) = c$. Si la matrice identifiée n'est pas définie positive, la qualité de l'ajustement est jugée insuffisante.

L'étape de vérification CHK de vérification de la qualité de l'ajustement peut également comprendre la détermination d'une transformation test permettant de transformer la surface paramétrique ajustée audit ensemble de mesures (i.e. la surface paramétrée à l'aide des paramètres déterminés à l'étape AJS), en une sphère, l'application de la transformation test aux mesures dudit ensemble pour fournir des mesures transformées et la détermination d'un degré d'ajustement des mesures transformées à la sphère.

La transformation test vise par exemple à transformer la surface paramétrée en une sphère unité et la détermination d'un degré d'ajustement des données transformées à la sphère comprend le calcul d'une erreur quadratique moyenne des distances entre la sphère unité et les mesures transformées. La norme de la i-ème mesure transformée $X_{i,c}$ (sa distance algébrique à la sphère unité) s'exprime selon $\|X_{i,c}\|_2 = \|D(X_i - b)\|_2$. La somme des erreurs quadratiques pour les N mesures de l'ensemble considéré s'écrit $\chi^2 = \Sigma_i(\|D(X_i - b)\|_2 - 1)^2$, et l'erreur quadratique moyenne s'exprime selon

$$\rho = \sqrt{\chi^2/N}$$

. Cette erreur est confrontée à un seuil (par exemple de 5%, ce qui correspond à une erreur d'environ 2 $\mu$T pour le champ magnétique terrestre d'amplitude 47 $\mu$T), pour décider si la qualité de l'ajustement est suffisante ou non.

Dans un mode de réalisation possible, on vient évaluer une éventuelle amélioration de la calibration. Pour ce faire, le procédé comprend l'application d'une transformation de calibration courante (i.e., la transformation actuellement appliquée aux mesures brutes) aux mesures dudit ensemble pour fournir des mesures calibrées, la détermination d'un degré d'ajustement des mesures calibrées à la sphère unité et la sélection UPD de la transformation test à la sphère unité en tant que nouvelle transformation de calibration courante si le degré d'ajustement des mesures transformées à la sphère unité est supérieur au degré d'ajustement des mesures calibrées à la sphère unité. La transformation courante est appliquée à l'intégralité des mesures délivrées par le magnétomètre, jusqu'à ce que lui soit substituée une nouvelle transformation associée à une surface paramétrique jugée mieux ajustée aux mesures.

La transformation test peut alternativement transformer la surface paramétrée en une sphère de rayon $B_0$, avec $B_0$ la norme du champ géomagnétique, et la détermination d'un degré d'ajustement des mesures transformées à la sphère peut comprendre le calcul d'une différence de norme entre les mesures transformées $X_c$ et la sphère de rayon $B_0$: $|\|X_c\|_2 - B_0|$. On évalue une caractéristique de cette différence de norme, par exemple son maximum ou l'un de ses percentiles (par exemple à 95%), que l'on compare à un seuil choisi au-dessus du niveau de bruit, par exemple de $5\mu$T, pour décider si la qualité de l'ajustement est suffisante ou non. Par ailleurs, cette caractéristique peut être exploitée pour autoriser la mise en oeuvre de la calibration automatique selon l'invention en cas d'observation d'une différence de norme trop importante, par exemple supérieure à $2\mu$T.

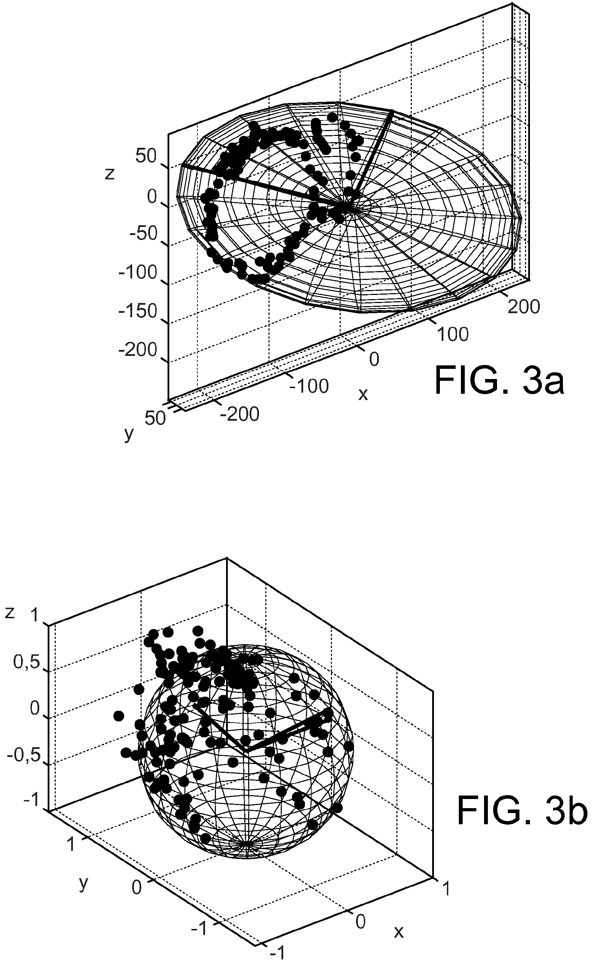

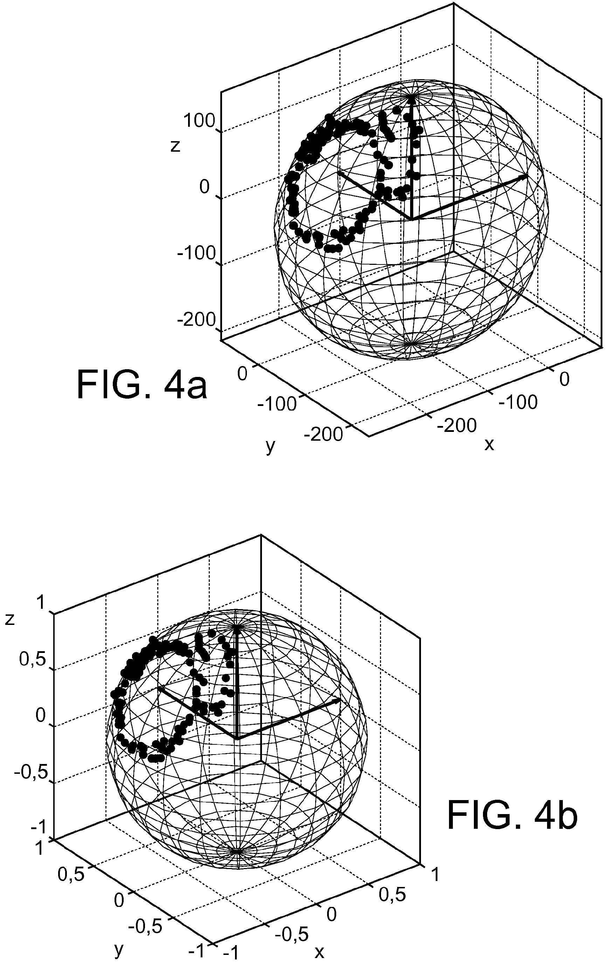

On a représenté sur les figures 3a et 4a une surface paramétrique ajustée à un ensemble de mesures du magnétomètre respectivement selon une méthode d'ajustement à un ellipsoïde en une étape et selon une méthode d'ajustement en deux étapes, l'indicateur r de distribution spatiale des mesures étant ici égal à 9.98. On a représenté sur la figure 3b, respectivement sur la figure 4b, les mesures calibrées par application de la transformation permettant de passer de la surface de la figure 3a, respectivement de la figure 4a, à la sphère unité. On constate que la méthode d'ajustement en deux étapes est ici plus appropriée que la méthode d'ajustement à un ellipsoïde en une étape.

L'invention n'est pas limitée au procédé tel que précédemment décrit, mais s'étend également à un produit programme d'ordinateur comprenant des instructions pour l'exécution de ce procédé lorsque ledit programme est exécuté sur un ordinateur. Et l'invention s'étend également à un dispositif, par exemple une centrale de navigation inertielle, comprenant une unité de traitement de données configurée pour mettre en oeuvre ce procédé.

## Revendications

1. Procédé mis en oeuvre par ordinateur de calibration d'un capteur tri-axe, comprenant des étapes de :

- calcul (DIS) d'un indicateur de distribution spatiale d'un ensemble de mesures délivrées par le capteur tri-axe pour évaluer la dispersion desdites mesures et

- détermination (AJS), selon une méthode d'ajustement, de paramètres d'une surface paramétrique permettant d'ajuster ladite surface paramétrique audit ensemble de mesures délivrées, **caractérisé en ce qu'**il comprend en outre une étape de sélection de la méthode d'ajustement parmi plusieurs méthodes d'ajustement prédéterminées en fonction dudit indicateur de distribution spatiale, **caractérisé en ce que** le calcul de l'indicateur de distribution spatiale comprend des sous-étapes de :

> - détermination d'une matrice de corrélation des mesures dudit ensemble
> - détermination d'un nombre de conditionnement de la matrice de corrélation correspondant au ratio de la valeur propre de la matrice de corrélation la plus grande sur la valeur propre de la matrice de corrélation la plus faible,

> ledit nombre de conditionnement formant l'indicateur de distribution spatiale.

2. Procédé selon la revendication 1, dans lequel les méthodes d'ajustement prédéterminées comprennent une méthode d'ajustement à un ellipsoïde, une méthode d'ajustement à une sphère et une méthode d'ajustement en deux étapes consistant en un premier ajustement à une sphère suivi d'un deuxième ajustement à un ellipsoïde dont le centre est confondu avec le centre de la sphère du premier ajustement.

3. Procédé selon la revendication 2, dans lequel lorsque l'indicateur de distribution spatiale est inférieur à un premier seuil, la méthode d'ajustement sélectionnée est la méthode d'ajustement à un ellipsoïde, lorsque l'indicateur de distribution spatiale est supérieur au premier seuil et inférieur à un deuxième seuil, la méthode d'ajustement sélectionnée est la méthode d'ajustement en deux étapes, et lorsque l'indicateur de distribution spatiale est supérieur au deuxième seuil, la méthode d'ajustement sélectionnée est la méthode d'ajustement à une sphère.

4. Procédé selon l'une des revendications 1 à 3, comprenant une étape préalable de sélection (SLT) des mesures dudit ensemble parmi les mesures délivrées par le capteur tri-axe, ladite étape préalable comprenant une estimation d'un changement d'orientation du capteur tri-axe entre les mesures délivrées et la sélection de mesures associées à des orientations du capteur jugées, au moyen d'une comparaison à un seuil, comme étant suffisamment différentes.

5. Procédé selon la revendication 4, dans lequel le capteur tri-axe est un magnétomètre et l'estimation d'un changement d'orientation du capteur entre les mesures délivrées comprend une détermination d'un écart entre l'amplitude d'une composante d'une mesure délivrée avec l'amplitude d'une composante d'au moins une des mesures préalablement sélectionnées.

6. Procédé selon la revendication 4, dans lequel dans lequel le capteur tri-axe est un magnétomètre et l'estimation d'un changement d'orientation du magnétomètre entre les mesures délivrées exploite des mesures délivrées par un gyromètre ou exploite à la fois les mesures délivrées par le magnétomètre et des mesures délivrées par un accéléromètre.

7. Procédé selon l'une des revendications 1 à 6, comprenant une détermination d'une transformation test permettant de transformer la surface paramétrique ajustée audit ensemble de mesures délivrées en une sphère unité, l'application de la transformation test aux mesures dudit ensemble pour fournir des mesures transformées et une détermination d'un degré d'ajustement des mesures transformées à la sphère unité.

8. Procédé selon la revendication 7, comprenant en outre une application d'une transformation de calibration courante aux mesures dudit ensemble pour fournir des mesures calibrées, une détermination d'un degré d'ajustement des mesures calibrées à la sphère unité et la sélection (UPD) de la transformation test en tant que nouvelle transformation de calibration courante si le degré d'ajustement des mesures transformées à la sphère unité est supérieur au degré d'ajustement des mesures calibrées à la sphère unité.

9. Programme d'ordinateur comprenant des instructions pour l'exécution du procédé selon l'une des revendications 1 à 8 lorsque ledit programme est exécuté sur un ordinateur.

10. Dispositif comprenant une unité de traitement de données configurée pour mettre en oeuvre le procédé selon l'une des revendications 1 à 8.

**Patentansprüche**

1. Verfahren zur Implementierung durch einen Computer der Kalibrierung eines Dreiachsensensors, die Schritte umfassend zum:

- Berechnen (DIS) eines Indikators der räumlichen Verteilung einer Reihe von Messungen, die vom Dreiachsensensor geliefert werden, um die Streuung dieser Messungen zu bewerten, und

- Bestimmen (AJS), gemäß einer Anpassungsmethode, von Parametern einer parametrischen Fläche, die es ermöglichen, die parametrische Fläche an die gelieferte Reihe von Messungen anzupassen, **dadurch gekennzeichnet, dass** es ferner einen Schritt zur Auswahl der Anpassungsmethode aus mehreren vorbestimmten Anpassungsmethoden in Abhängigkeit des Indikators der räumlichen Verteilung umfasst, **dadurch gekennzeichnet, dass** die Berechnung des Indikators der räumlichen Verteilung die Teilschritte umfasst zum:

- Bestimmen einer Matrix der Korrelation der Messungen der Reihe,

- Bestimmen einer Konditionierungszahl der Korrelationsmatrix, die dem Verhältnis des Eigenwerts der größten Korrelationsmatrix zum Eigenwert der niedrigsten Korrelationsmatrix entspricht,

wobei die Konditionierungszahl den Indikator der räumlichen Verteilung bildet.

2. Verfahren nach Anspruch 1, wobei die vorbestimmten Anpassungsmethoden eine Anpassungsmethode mit einem Ellipsoid umfassen, eine Anpassungsmethode mit einer Kugel und eine Anpassungsmethode mit zwei Schritten, die aus einer ersten Anpassung an eine Kugel gefolgt von einer zweiten Anpassung an ein Ellipsoid, dessen Mittelpunkt mit dem Mittelpunkt der Kugel der ersten Anpassung übereinstimmt, besteht.

3. Verfahren nach Anspruch 2, wobei, wenn der Indikator der räumlichen Verteilung kleiner als ein erster Schwellenwert ist, die ausgewählte Anpassungsmethode die Ellipsoid-Anpassungsmethode ist, und wenn der Indikator der räumlichen Verteilung größer als der erste Schwellenwert und kleiner als ein zweiter Schwellenwert ist, die ausgewählte Anpassungsmethode die Anpassungsmethode mit zwei Schritten ist, und wenn der Indikator der räumlichen Verteilung größer als der zweite Schwellenwert ist, die ausgewählte Anpassungsmethode die Kugel-Anpassungsmethode ist.

4. Verfahren nach einem der Ansprüche 1 bis 3, einen vorgängigen Schritt (SLT) der Auswahl der Messungen der Reihe aus den vom Dreiachsensensor gelieferten Messungen umfassend, wobei der vorgängige Auswahlschritt eine Schätzung einer Änderung der Ausrichtung des Dreiachsensensors zwischen den gelieferten Messungen und der Auswahl von Messungen umfasst, die mit Sensorausrichtungen assoziiert sind, die durch einen Vergleich eines Schwellenwerts als ausreichend unterschiedlich beurteilt werden.

5. Verfahren nach Anspruch 4, wobei der Dreiachsensensor ein Magnetometer ist und die Schätzung einer Änderung der Sensorausrichtung zwischen den gelieferten Messungen eine Bestimmung einer Abweichung zwischen der Amplitude einer Komponente einer gelieferten Messung und der Amplitude einer Komponente mindestens einer der zuvor ausgewählten Messungen umfasst.

6. Verfahren nach Anspruch 4, wobei der Dreiachsensensor ein Magnetometer ist und die Schätzung einer Änderung der Ausrichtung des Magnetometers zwischen den gelieferten Messungen Messungen auswertet, die von einem Gyrometer geliefert werden, oder sowohl Messungen, die vom Magnetometer geliefert werden, als auch Messungen, die von einem Beschleunigungsmesser geliefert werden, auswertet.

7. Verfahren nach einem der Ansprüche 1 bis 6, eine Bestimmung eines Transformationstests umfassend, die es ermöglicht, die parametrische Fläche, die an die Reihe von gelieferten Messungen angepasst ist, in eine Einheitskugel zu transformieren, die Anwendung des Transformationstests auf die Messungen der Reihe, um transformierte Messungen bereitzustellen, und eine Bestimmung eines Anpassungsgrades der transformierten Messungen an die Einheitskugel.

8. Verfahren nach Anspruch 7, ferner eine Anwendung einer aktuellen Kalibrierungstransformation auf die Messungen in der Reihe umfassend, um kalibrierte Messungen bereitzustellen, eine Bestimmung eines Anpassungsgrades der kalibrierten Messungen an die Einheitskugel, und die Auswahl (UPD) der Transformationstests als neue aktuelle Kalibrierungstransformation, wenn der Anpassungsgrad der transformierten Messungen an die Einheitskugel größer ist als der Anpassungsgrad der kalibrierten Messungen an die Einheitskugel.

9. Computerprogramm, Anweisungen zur Ausführung des Verfahrens nach einem der Ansprüche 1 bis 8 umfassend, wenn das Programm auf einem Computer ausgeführt wird.

10. Vorrichtung, eine Datenverarbeitungseinheit umfassend, die zur Implementierung des Verfahrens nach einem der Ansprüche 1 bis 8 konfiguriert ist.

**Claims**

1.  A computer-implemented method for calibrating a triaxial sensor, comprising the steps of:

    - calculating (DIS) a spatial distribution indicator of a set of measurements output by the triaxial sensor, and
    - determining (AJS), using a fitting method, parameters of a parametric surface that can be used to fit said surface to said set of output measurements,

    **characterized in that** it includes a step of selecting the fitting method from among several predetermined fitting methods as a function of said spatial distribution indicator, **characterized in that** calculating the spatial distribution indicator comprises sub-steps of:

    - determining a correlation matrix of measurements of said set,
    - determining the condition number of the correlation matrix, corresponding to the ratio of the eigenvalue of the largest correlation matrix to the eigenvalue of the smallest correlation matrix, said condition number forming the spatial distribution indicator.

2.  Method according to claim 1, wherein the predetermined fitting methods include an ellipsoid fitting method, a sphere fitting method and two-step fitting method consisting of a first fitting to a sphere followed by a second fitting to an ellipsoid the centre of which is coincident with the centre of the sphere of the first fitting.

3.  Method according to claim 2, wherein when the spatial distribution indicator is less than a first threshold, the selected fitting method is the ellipsoid fitting method, when the spatial ellipsoid distribution indicator is more than the first threshold and less than a second threshold, the selected fitting method is the two-step fitting method, and when the spatial distribution indicator is more than the second threshold, the selected fitting method is the sphere fitting method.

4.  Method according to any of the claims 1 to 3, further including a preliminary step (SLT) of selecting the measurements of said set among the measurements output by the triaxial sensor, said preliminary step comprising estimating a change in the orientation of the triaxial sensor between the output measurements and selecting measurements associated with sensor orientations deemed to be sufficiently different by comparison with a threshold.

5.  Method according to claim 4, wherein the triaxial sensor is a magnetometer and estimating a change in the sensor orientation between the output measurements includes determining a difference between the amplitude of an output measurement component and the amplitude of a component of at least one of previously selected measurements.

6.  Method according to claim 4, wherein the triaxial sensor is a magnetometer and estimating a change in the orientation of the magnetometer between the output measurements makes use of measurements output by a gyrometer, or uses both measurements output by the magnetometer and measurements output by an accelerometer.

7.  Method according to any of the claims 1 to 6, further including determining of a test transformation that transforms the parametric surface fitted to said set of output measurements into a unit sphere, applying the test transformation to the measurements of said set to obtain transformed measurements and determining a degree of fit of the transformed measurements to the unit sphere.

8.  Method according to claim 7, further including applying a current calibration transformation to the measurements of said set to obtain calibrated measurements, determining a degree of fit of the calibrated measurements to the unit sphere and selecting the test transformation as a new current calibration transformation if the degree of fit of the transformed measurements to the unit sphere is more than the degree of fit of the calibrated measurements to the unit sphere.

9.  A computer program including instructions for execution of the method according to any of the claims 1 to 8 when said program is executed on a computer.

10. A device comprising a data processing unit configured to use the method according to any of the claims 1 to 8.

FIG. 1a

FIG. 1b

FIG. 2

FIG. 3a

FIG. 3b

FIG. 4a

FIG. 4b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 03074969 A2
- WO 2007026238 A1

**Littérature non-brevet citée dans la description**

- **A. OLIVARES et al.** Automatic Détermination of Validity of Input Data Used in Ellipsoid Fitting MARG Calibration Algorithms. *Sensors,* Septembre 2013, vol. 13 (9), 11797-11817
- **M. GIETZELT et al.** Performance comparison of accelerometer calibration algorithms based on 3D-ellipsoid fitting methods. *Comput. Methods Programs Biomed.,* Juillet 2013, vol. 111 (1), 62-71